# EUROPEAN PATENT APPLICATION

(11) **EP 1 589 618 A1**
(43) Date of publication of application: **26.10.2005**
(21) Application number: 05103244.9
(22) Date of filing: 21.04.2005
(51) Int. Cl.: H01R 12/32

(54) **Electronic device with a contact pin and method for producing such a device**

(30) Priority: 23.04.2004 IT MI20040805
(71) Applicant: VIMERCATI S.p.A., 20121 MILANO (IT)
(72) Inventor: Ricco, Dionigi, 20021, BARANZATE (IT)
(74) Representative: Jorio, Paolo

(57) **Abstract**

An electronic device (1; 23; 26) has a contact pin (9) inserted inside a hole (5) on a printed circuit board (PCB1; PCB2; PCB3); the contact pin (9) is connected to the inner face (6) of the hole (6) to form a solely mechanical connection, the inner face (6) having no plating, and electrical contact being achieved by soldering the contact pin (9) to a pad (8; 24; 27).

## Description

The present invention relates to an electronic device with a contact pin.

More specifically, the present invention relates to an electronic device of the type comprising a printed circuit board (PCB) fitted with contact pins. Electronic devices of this sort are used as straightforward connectors or as actual processing boards when fitted with circuit components such as capacitors, resistors, diodes, etc..

Printed circuits are normally formed on a board made of FR-4, i.e. a material comprising glass fibre and epoxy resin with a glass transition temperature of 135°C. The board is punched to form through holes, and has a first and second side, which are plated with respective copper plates on which the circuits are formed by etching conducting tracks and pads. The inner faces of the through holes are then plated by electrodeposition to form an electrical contact between the circuits on the first and second sides and to make the inner faces of the holes conductive (PTH : plated through holes). At this point, the circuit components are fitted to the first side, and the contacts are inserted on the second side. Each contact pin is elongated in shape, with two transverse arms. In use, the elongated portion must be maintained perpendicular to the board, while the arms define the position in which the pin rests on the board. Part of the elongated portion is located inside the plated through hole, and has a central through slit forming two rods, which are outwardly convex to exert elastic force on the wall of the through hole when inserted inside the through hole. Between the two rods, some contact pins have resilient mechanisms for pushing the rods outwards. The elasticity of the rods provides for forming a mechanical fit and electrical contact between the contact pin and the plated face of the through hole.

While providing for reliable devices, the above method is extremely expensive on account of the complexity of the contact pin, and also of the board, which must be made of materials capable of withstanding the relatively severe stress caused by insertion of the contact pin.

It is an object of the present invention to provide an electronic device of the type described above, designed to eliminate the drawbacks of the known art, and which in particular is cheap to produce.

According to the present invention, there is provided an electronic device as claimed in Claim 1.

The present invention also relates to a method of producing an electronic device.

According to the present invention, there is provide a method as claimed in Claim 10.

A number of preferred embodiments of the present invention will be described by way of example with reference to the accompanying drawings, in which:
Figure 1 shows a plan view, with parts removed for clarity, of an electronic device in accordance with the present invention;
Figure 2 shows a section along line II-II of the Figure 1 electronic device;
Figure 3 shows a larger-scale section along line III-III in Figure 2;
Figure 4 shows a larger-scale section along line IV-IV in Figure 2;
Figure 5 shows a plan view, with parts removed for clarity of a second embodiment of a device in accordance with the present invention;
Figure 6 shows a section along line VI-VI of the Figure 5 device;
Figure 7 shows a plan view, with parts removed for clarity of a third embodiment of a device in accordance with the present invention;
Figure 8 shows a section along line VIII-VIII of the Figure 7 device;
Figure 9 shows an underside plan view, with parts removed for clarity, of the Figure 7 device;
Figure 10 shows a larger-scale side view of a detail of the pin according to the present invention.

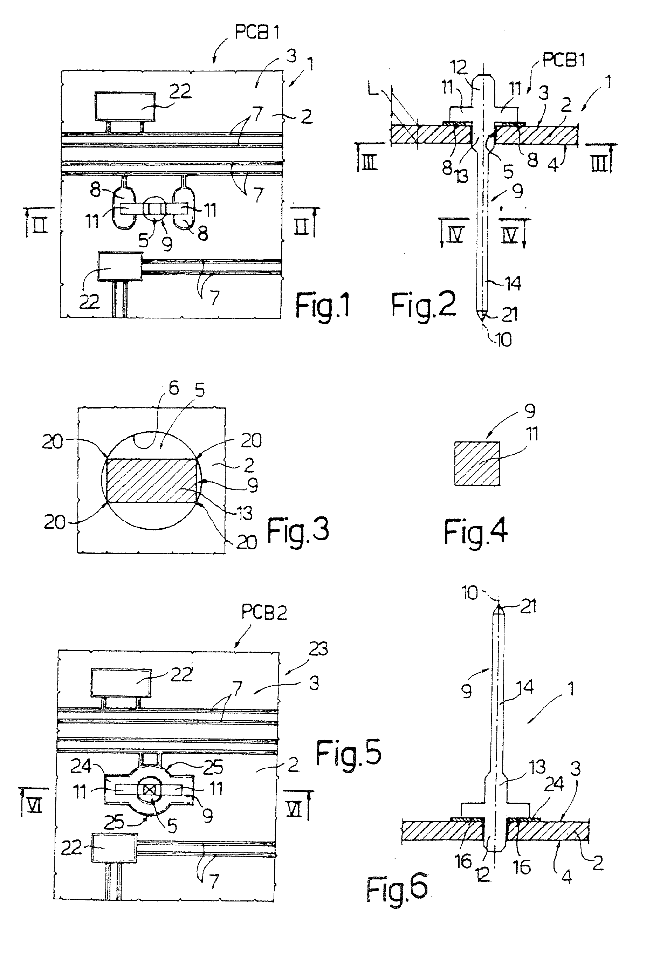

Number 1 in Figure 1 indicates as a whole an electronic device having a printed circuit board PCB1 comprising a board 2. With reference to Figure 2, board 2 comprises a side 3, and a side 4 parallel to side 3 so as to define a substantially constant thickness L; and a through hole 5 bounded by a face 6 (Figure 3).

With reference to Figure 1, side 3 is copper plated, and tracks 7 and two pads 8 are etched on diametrically opposite sides of hole 5.

In the example described, reference is made, for the sake of simplicity, to a portion of board 2 comprising one hole 5 and two pads 8, though it is clearly understood that printed circuit board PCB1 comprises a number of holes 5 and pads 8.

Each pad 8 is substantially oval and located a distance from the edge of hole 5.

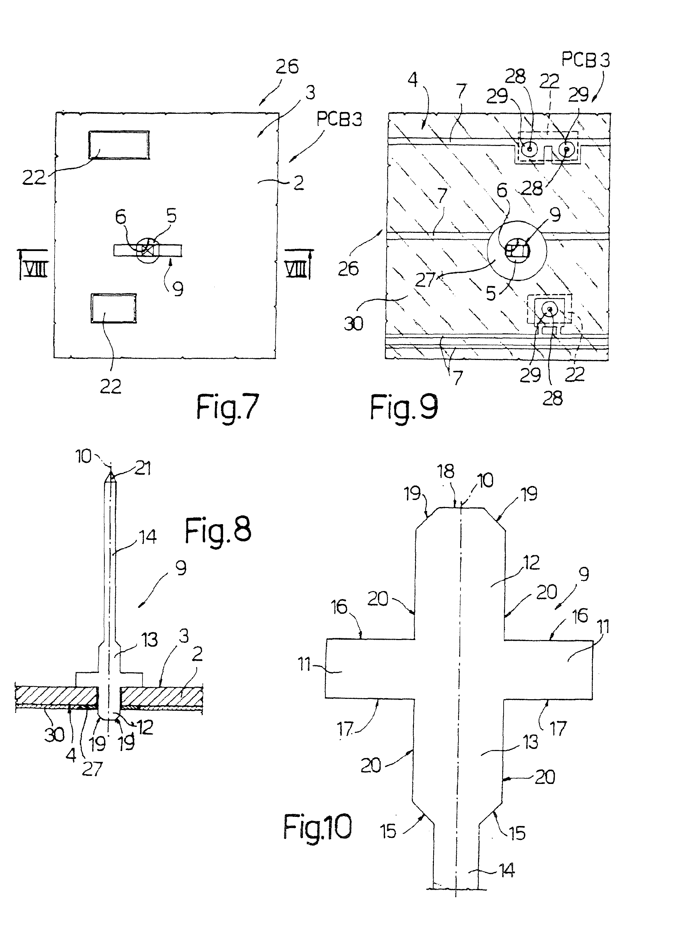

With reference to Figures 1 and 2, the device also comprises an elongated contact pin 9 extending along an axis 10 perpendicular, in use, to sides 3 and 4 of board 2. Pin 9 is blanked from sheet metal and is normally rectangular in cross section. With reference to Figure 10, contact pin 9 is substantially cross-shaped, and comprises two arms 11 perpendicular to axis 10; two fastening portions 12 and 13; and a connecting portion 14.

Portions 12, 13, 14 are arranged successively along axis 10. More specifically, fastening portions 12 and 13 are located on opposite sides of arms 11, while portion 14, which is smaller in cross section than portion 13, is connected to portion 13 by two faces 15 sloping with respect to axis 10. Each arm 11 has a face 16 and a face 17, which are perpendicular to axis 10 and are positioned contacting a respective pad 8.

The outer end of portion 12 is defined by a face 18 perpendicular to axis 10, and by two inclined lateral faces 19; portions 12 and 13 have edges 20 which cooperate with inner face 6 of hole 5; and portion 14 has a tapered outer end 21 for easy insertion of portion 14.

Figure 3 shows the cross section of portion 13 contacting inner face 6 of hole 5 along edges 20; and Figure 4 shows the cross section of portion 14 smaller than the cross section of portion 13.

Number 22 in Figure 1 indicates electronic components, such as diodes, capacitors, resistors, etc., fitted to side 3 of board 2.

The method of producing device 1 comprises plating board 2 along side 3 only, and forming tracks 7 and pads 8; contact pins 9 and electronic components 22 are then inserted on the same side, i.e. side 3; and contact pins 9 are then SMT (surface mounting technology) soldered. Briefly, SMT comprises applying small amounts of soldering paste to the areas to be joined, such as arms 11 and pads 8; after which, board 2 is placed inside an oven where the soldering paste adheres to pads 8 and arms 11 to form the electrical contact between contact pin 9 and pad 8, i.e. the printed circuit.

In this embodiment, board 2 is only plated along side 3, so that holes 5 cannot be plated, and components 22 are inserted and soldered on side 3 only, so that, throughout the production process, board 2 is never turned over, thus saving considerable time. Moreover, contact between contact pin 9 and face 6 of the hole serves solely to keep contact pin 9 perpendicular to board 2, and the insertion forces are reduced, so that board 2 may be made of CEM 1 or CEM 3, which have a lower mechanical resistance than FR-4 and are decidedly cheaper. Finally, contact pin 9 is blanked from a sheet metal strip and is therefore much cheaper than round-section contacts. Taken together, all the above features provide for a roughly 30% reduction in the cost of device 1. The two pads 8 have the advantage of limiting flow of the soldering paste along the relatively small pad 8, and of preventing the soldering paste from flowing into hole 5. The soldering paste, in fact, flows along the metal pad, but is halted by the rougher surface of board 2.

With reference to Figures 5 and 6, number 23 indicates an electronic device, which differs from device 1 by board PCB1 being replaced by a board PCB2, and by contact pin 9 being inserted by portion 12. Board PCB2 in turn differs from board PCB1 by pads 8 being replaced by a single pad 24, which extends about hole 5 and is substantially rectangular with two curved areas 25 located along the long sides with their convexities facing away from hole 5. Portion 12 is inserted inside hole 5 with relative edges 20 contacting inner face 6 of the hole to form the mechanical fit. Faces 16 of the arms contact pad 24, and arms 11 are SMT soldered to pad 24.

Electronic device 23 is produced using substantially the same method as described for electronic device 1, except that fastening portion 12 is inserted inside hole 5 instead of fastening portion 13.

With reference to Figures 7, 8, 9, number 26 indicates an electronic device comprising a printed circuit board PCB3, which has numerous elements in common with printed circuit board PCB1 as described above, and which are indicated using the same reference numbers as for the corresponding elements of board PCB1. In addition to the elements in common with board PCB1, board PCB3 also comprises an annular pad 27 surrounding hole 5 on side 4 of board 2 (Figure 9). Electronic device 26 also differs from devices 1 and 23 by components 22 comprising fastening pins 28 engaging respective through holes in board 2. A pad 29 surrounds each hole on side 4 to fasten pins 28 of components 22. Conducting tracks 7 are also formed on side 4, which is covered with a transparent protective layer 30 except for pads 27 and 29.

The method of producing electronic device 26 comprises plating board 2 on side 4, and forming tracks 7 and pads 27 and 29 on side 4. Contact pin 9 is inserted inside hole 5 and pins 28 of electronic components 22 are inserted inside respective holes on the same side, i.e. side 3, and are then flow soldered on side 4. Briefly, flow soldering comprises sweeping side 4 with a wave formed in a bath of molten metal, which adheres to the metal parts : pads 27 and 29, faces 18 and 19 of contact pin 9, and the projecting parts of the pins of components 22, to form the respective joints.

As before, portion 12 inserted forcefully inside hole 5 provides for mechanical fit, while soldering contact pin 9, which in this case is soldered between faces 18, 19 and pad 27, provides for electrical contact.

## Claims

1. An electronic device (1; 23; 26) comprising a contact pin (9), and a printed circuit board (PCB1; PCB2; PCB3) having a hole (5) for housing the contact pin (9); the electronic device being **characterized in that** said hole (5) has an inner face (6) with no plating; connection between said contact pin (9) and said hole (5) serving solely to connect the board (2) mechanically to the contact pin (9); and the contact pin (9) being soldered to a pad (8; 24; 27) to form electrical contact.

2. A device as claimed in Claim 1, **characterized in that** said printed circuit board (PCB1; PCB2; PCB3) comprises a board (2) having a first and a second side (3, 4); said pad (8; 24; 27) of conducting material being located about said hole (5) on said first side or said second side (3, 4).

3. A device as claimed in either of the foregoing Claims, **characterized by** comprising electronic components (22) on the first side (3).

4. A device as claimed in any one of the foregoing Claims, **characterized in that** said contact pin (9) comprises a first fastening portion (12; 13) for mechanical connection of said hole (5) and the contact pin (9).

5. A device as claimed in Claim 4, **characterized in that** said contact pin (9) comprises a first and a second fastening portion (12, 13).

6. A device as claimed in Claim 5, **characterized in that** said contact pin (9) comprises a first and a second arm (11) parallel to and aligned with each other; said first and said second fastening portion (12, 13) being located on opposite sides of said first and said second arm (11).

7. A device as claimed in any one of Claims 4 to 6, **characterized in that** said first fastening portion (12; 13) has a substantially rectangular cross section; said first fastening portion (12; 13) contacting the inner face (6) of said hole (5) along respective edges (20).

8. A device as claimed in Claim 6 or 7, **characterized in that** each first and second arm (11) comprises a first and a second contact face (16, 17), each of which is positioned contacting a respective pad (24; 8) .

9. A device as claimed in any one of the foregoing Claims, **characterized in that** two pads (8) are located about said hole (5), on diametrically opposite sides of said hole (5), and at a distance from said hole (5).

10. A method of producing an electronic device (1; 23; 26) comprising a contact pin (9), and a printed circuit board (PCB1; PCB2; PCB3) having a hole (5) for housing the contact pin (9); the method being **characterized by** not plating the inner face (6) of the hole (5); inserting the contact pin (9) inside the hole to form a mechanical connection between said contact pin (9) and said hole (5); and soldering the contact pin (9) to a pad (8; 24; 27) to form electrical contact.

11. A method as claimed in Claim 10, wherein said printed circuit board (PCB1; PCB2; PCB3) comprises a board (2) having a first and a second side (3, 4); the method being **characterized in that** said pad (8; 24; 27) of conducting material is located about said hole (5) on said first side or said second side (3, 4).

12. A method as claimed in Claim 11, **characterized by** plating said first side (3), inserting said contact pin (9) on the first side (3), and soldering using SMT technology.

13. A method as claimed in Claim 11, **characterized by** plating the second side (4), inserting said contact pin (9) on the first side, and flow soldering on the second side (4).

14. A method as claimed in Claim 12 or 13, **characterized by** placing electronic components on said first side (3).

15. A method as claimed in any one of the Claims from 10 to 14, **characterized in that** said board (2) is made of CEM1 or CEM3 material.
